# EUROPEAN PATENT APPLICATION

(11) **EP 3 037 580 A1**
(43) Date of publication of application: **29.06.2016**
(21) Application number: 15200352.1
(22) Date of filing: 16.12.2015
(51) Int. Cl.: D06F 39/00, A47L 15/42

(54) **FREE-STANDING HOUSEHOLD APPLIANCE**

(30) Priority: 23.12.2014 IT PR20140101
(71) Applicant: Indesit Company S.p.A., 60044 Fabriano (AN) (IT)
(72) Inventor: PITTALIS, Giacomo, 60018 Montemarciano (AN) (IT); POLVERINI, Elisa, 60039 Staffolo (AN) (IT); TARABU', Roberto, 60036 Montecarotto (AN) (IT); ANDRENACCI, Luca, 60035 Jesi (AN) (IT); CATANI, Romina, 60035 Jesi (AN) (IT); KHALFAOUI, Zakaria, 62019 Recanati (MC) (IT); MATARAZZI, Filippo, 06023 Gualdo Tadino (PG) (IT); FALSETTI, Alessandro, 10145 Torino (IT)
(74) Representative: Santonicola, Paolo

(57) **Abstract**

A free-standing household appliance comprising:
-an external casing (2) accessible to the user;
-a first user interface (3) that can be extracted from said external casing (2);
-sliding means (4) for sliding the first user interface;
-tilting means (5) for tilting said first user interface (3) with respect to the sliding means (4).

## Description

The present invention relates to a free-standing household appliance provided with a user interface.

There are known washing machines comprising a user interface which enables a user to give instructions or more in general to dialogue with the household appliance. The user interface is located on the front.

The user is in fact usually positioned in front of the washing machine to give or receive instructions.

Such interface is not immediately visible, however, to a user of medium stature who is standing close to the front of the washing machine (in such a case, given the height of the washing machine, he or she would see the top, not the front). In order to view the interface located on the front, the user would have to move back a few steps or bend over so that his or her eyes are more or less at the same height as the interface.

In this context, the technical task at the basis of the present invention is to propose a household appliance that enables to overcome the aforementioned disadvantages.

In particular, the object of the present invention is to enhance the ergonomics of the household appliance.

The technical task set and the objects specified are substantially attained by a household appliance, comprising the technical characteristics as set out in one or more of the accompanying claims.

Further characteristics and advantages of the present invention will become more apparent from the following approximate, and hence non-limiting, description of a preferred, but not exclusive, embodiment of an household appliance as illustrated in the accompanying drawings, in which:

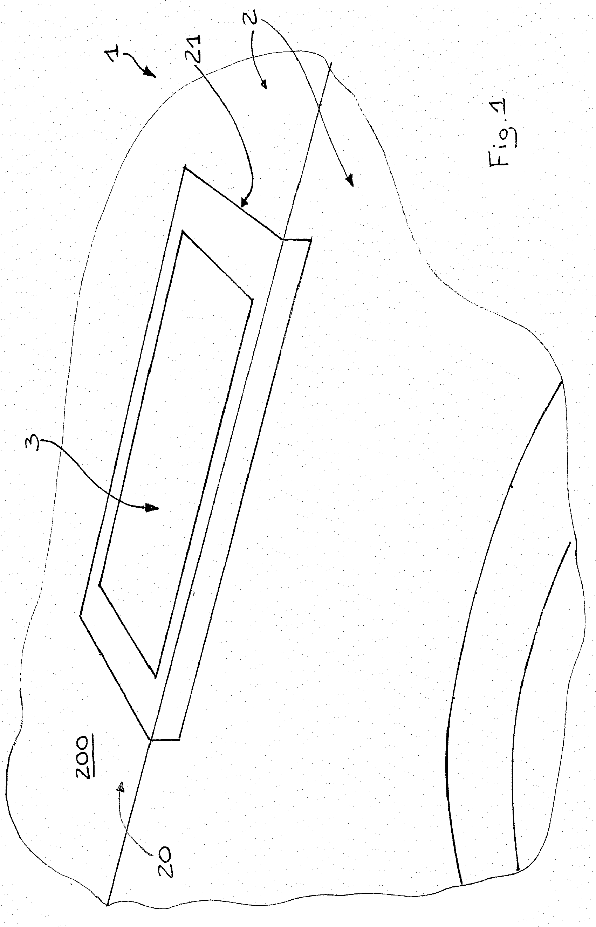

-figures 1-3 show a detail of a household appliance according to the present invention in three different configurations.

In the accompanying figures, the reference number 1 denotes a household appliance. The household appliance 1 is a free-standing household appliance.

It comprises an external casing 2 accessible to the user. In the technical jargon, the casing 2 is also defined as a "cabinet".

The household appliance 1 comprises a first user interface 3 that can be extracted from said external casing 2.

For this purpose, the household appliance 1 comprises:
- a sliding means 4 for sliding the first user interface 3;
- a tilting means 5 for tilting said first user interface 3. The means 5 enables the first interface 3 to be tilted with respect to the sliding means 4. The external casing 2 comprises a top 20. The top 20 means the upper part of the household appliance 1. In particular, the top 20 means the upper surface of the household appliance 1. Preferably, the top 20 comprises a housing 21.

The first user interface 3 takes on at least a first position (see figure 1), wherein it is located inside the housing 21 of the external casing 2. The user interface 3 can comprise a touch screen display. In the first position, the first user interface 3 (for example the touch screen display) is facing upwards. In this manner it is directly visible and accessible to a user observing the top 20 from above. Alternatively, the first user interface 3 could comprise different types of selectors whose footprint, in the first position, is confined, however, within the volume defined by the housing 21.

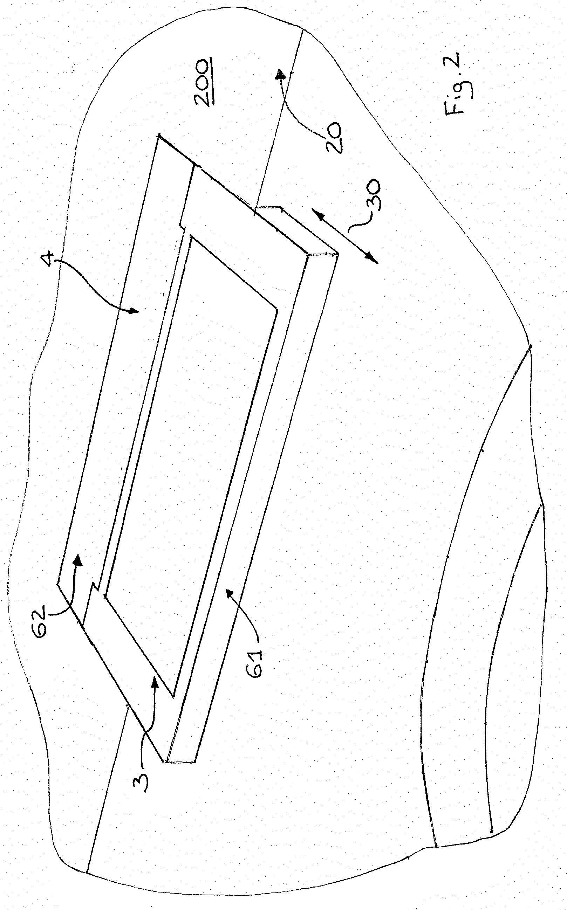

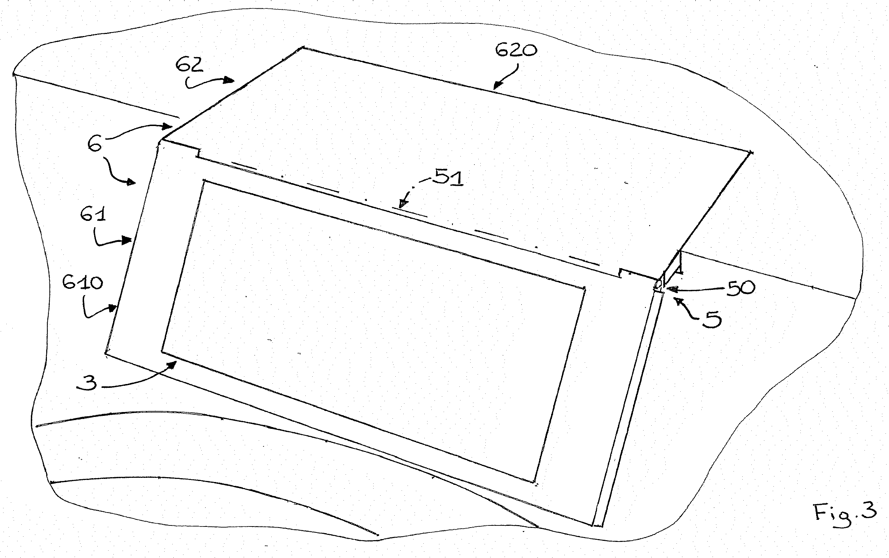

The first user interface 3 takes on a second position (an intermediate situation between the one in figure 2 and the one in figure 3), wherein:
- it is extracted from said housing 21;
- it is not tilted with respect to the first position;
- the tilting means 5, conveniently, is at least partly extracted from said housing 21. Advantageously, the tilting means 5 comprises one or more hinges 50 (which in the second position are extracted from the housing 21).

Conveniently, at least an end part of the travel of the first user interface 3 during extraction is braked. An extraction limit stop is also provided for the first user interface 3.

In one particular embodiment, the household appliance 1 comprises a means for retaining the first interface 3 in the first position. The household appliance 1 further comprises a means to release said retaining means. For example, the release means could comprise a push-push device.

The first user interface 3 further comprises a third position (see figure 3), wherein the first user interface is tilted with respect to a direction 30 for extraction of the first user interface 3.

Conveniently, the hinge 50 defines a horizontal axis of rotation 51 which is perpendicular to the extraction direction 30.

In the preferred embodiment, the housing 21 is open at the top so as to enable a user to reach said first user interface 3 from above. The housing 21 is open at the front so as to enable extraction of the first user interface 3 from the front.

The household appliance 1 comprises a folding structure 6 comprising a first and a second flap 61, 62 that are connected to each other by the tilting means 5.

The first flap 61 could be a plate, preferably parallelepiped. The second flap 62 could also be a plate, preferably parallelepiped.

The first user interface 3 is located in the first flap 61.

The second flap 62 at least partially incorporates the sliding means 4.

The second flap 62 houses within it any wiring serving to supply electricity to the first interface 3.

The sliding means 4 comprises sliding guides along which the second flap 62 can slide. Advantageously, two lateral guides are present, as well as a guide located on a bottom of the housing 21.

The second flap 62 advantageously comprises sliding blocks or sliders which slide along the two lateral guides and/or the guide located on the bottom of the housing 21.

In one particular embodiment, the second flap 62 could comprise a second user interface. The second interface could be an additional interface which, for example, provides more information than the first interface 3. In this regard, the first interface 3 could be a simplified interface, whilst the second interface could be a complex interface that provides greater information.

The hinge 50 of the tilting means 5 is interposed between the first and the second flap 61, 62.

The supply of electricity to the first interface 3 located in the first flap 61 entails the use of sliding contacts or wires passing over the hinge 50.

The sliding means 4 brings about a horizontal extraction of the first user interface 3 (and more in general of the first flap 61).

In fact, in the first position of the first user interface 3, the housing 21 is occupied by the first flap 61. In the first position, the second flap 62 is at least in part inserted in a pocket defined by the external casing 2, said pocket extending in a continuous fashion from a rear area of said housing 21. Conveniently, the pocket precludes the visibility of what is inserted inside it.

In the second and third positions of the first user interface 3, the same housing 21 is occupied by the second flap 62.

What has been described previously with reference to the first and/or second flap 61, 62 could more generically refer to a first and/or second structure 610, 620.

In the first position, the first user interface 3 is facing upwards. In particular, in the first position of the user interface 3, the touch screen display is facing upwards. It is directly accessible to an outside user.

In the third position (see figure 3), the first user interface 3 is facing the front. In particular, the first interface 3 could also be facing the front, but simultaneously tilted up or down.

In the first position, the first user interface 3 is flush with an upper plane 200 of the top 20.

In the preferred embodiment, the household appliance 1 is a household appliance for washing or drying textile items.

Although as described previously and in the appended drawings, the housing 21 is made in the top, in an alternative embodiment it could also be made in the front part of the household appliance.

In such a case, the first user interface 3 can be inserted in the housing 21 and be facing the front.

The first user interface 3 can then be extracted vertically from the housing 21 and a subsequent tilting of the same on the top is possible. In this manner, the user can have a view of it also when observing the top from above.

The present invention further relates to a method for extracting a first user interface from the top of a household appliance. The household appliance has one or more of the previously described features.

The method comprises the steps of:
- extracting said first user interface 3 from the top by having said first user interface 3 slide horizontally;
- orienting said first user interface 3 extracted from the top about a horizontal axis of rotation 51 defined by said tilting means 5.

Conveniently, before rotating the first interface 3 about the tilting axis 51, the axis 51 is extracted from a housing fashioned on the top and intended to accommodate the first interface 3.

The invention thus conceived makes it possible to achieve multiple advantages.

Firstly, it enables the ergonomics of the user interface to be optimised. In fact, in the first position, the user interface is visible to a user who observes the top from above. In the third position, on the other hand, the user interface is visible to a user who observes the household appliance from the front (even if he or she is squatting in front of it). For example, the user could be squatting in front of the window of a washing machine while introducing or removing laundry from a washing compartment and could need to check at a glance (without standing up) what type of washing program is set or other operating parameters of the machine.

The invention thus conceived is susceptible to numerous modifications and variants, all of which falling within the scope of the inventive concept characterizing the invention. Moreover, all details may be replaced with other technically equivalent elements. In practice, all the materials used, as well as the dimensions, can be any according to requirements.

## Claims

1. A free-standing household appliance comprising:
- an external casing (2) accessible to the user;
- a first user interface (3) that can be extracted from said external casing (2);
**characterized in that** it comprises:
- sliding means (4) for sliding the first user interface (3);
- tilting means (5) for tilting said first user interface (3) with respect to the sliding means (4).

2. The household appliance according to claim 1, **characterized in that** the external casing (2) comprises a top (20) that comprises a housing (21); said first user interface (3) taking on:
- a first position, wherein it is located inside the housing (21) in the external casing (2);
- a second position, wherein the first user interface (3) and the tilting means (5) are extracted from said housing (21);
- a third position, wherein the first user interface (3) is tilted with respect to a direction (30) for extraction of the first user interface (3).

3. The household appliance according to claim 2, **characterized in that** said housing (21) is open at the top and at the front so as to enable the first user interface (3) to be reached from above and to enable extraction of the first user interface (3) from the front.

4. The household appliance according to claim 2 or 3, **characterized in that** in the first position, said first user interface (3) is facing upwards and in the third position, it is facing the front.

5. The household appliance according to claim 2 or 3 or 4, **characterized in that** in the first position, said first user interface (3) is flush with an upper plane (200) of the top (20).

6. The household appliance according to any one of the preceding claims, **characterized in that** it comprises a folding structure (6) comprising a first and a second flap (61, 62) that are connected to each other by the tilting means (5), the first user interface (3) being located in the first flap (61), the sliding means (4) being at least partially afforded in the second flap (62) and the tilting means (5) comprising a hinge (50) interposed between the first and the second flap (61, 62).

7. The household appliance according to claim 6, when directly or indirectly dependent upon claim 2, **characterized in that**:
- in the first position of the first user interface (3), said housing (21) is occupied by the first flap (61);
- in the second and third positions of the first user interface (3), said housing (21) is occupied by the second flap (62).

8. The household appliance according to any one of the preceding claims, **characterized in that** the sliding means (4) brings about a horizontal extraction of the first user interface (3).

9. The household appliance according to any one of the preceding claims, **characterized in that** it consists of a household appliance for washing or drying textile items.

10. A method for extracting a first user interface from the top of a household appliance according to any one of claims 1 to 9, **characterized in that** it comprises the steps of:
- extracting said first user interface (3) from the top by having said first user interface (3) slide horizontally;
- orienting said first user interface (3) extracted from the top about a horizontal axis of rotation (51) defined by said tilting means.
